Europäisches Patentamt

European Patent Office

Office européen des brevets

(19)

(11) Veröffentlichungsnummer: **0 195 223 B1**

(12) # EUROPÄISCHE PATENTSCHRIFT

(45) Veröffentlichungstag der Patentschrift: **07.08.91**

(21) Anmeldenummer: **86101567.5**

(22) Anmeldetag: **07.02.86**

(51) Int. Cl.⁵: **H05K 3/00**, H05K 3/24, H05K 3/10, C23C 16/18

(54) Herstellung metallischer Strukturen auf Nichtleitern.

(30) Priorität: **22.03.85 DE 3510982**

(43) Veröffentlichungstag der Anmeldung:
**24.09.86 Patentblatt 86/39**

(45) Bekanntmachung des Hinweises auf die Patenterteilung:
**07.08.91 Patentblatt 91/32**

(84) Benannte Vertragsstaaten:
**DE FR GB IT**

(56) Entgegenhaltungen:
EP-A- 0 095 256
EP-A- 0 158 536
GB-A- 2 066 583

THIN SOLID FILMS, Band 97, Nr. 1, November 1982, Seiten 17-29, Elsevier Sequoia, Lausanne, CH; R.K. SADHIR et al.: "Preparation of metallic organotin films by glow discharge polymerization and their properties"

Idem

TRANSACTIONS OF THE INSTITUTE OF METAL FINISHING, Band 61, Nr. 2, 1983, Seiten 60-63, London, GB; D.R. GABE: "Electroplating for electronic applications: a process reappraisal"

Solid State Technology, Band 26, Nr. 3, März 1983, S. 125-128

(73) Patentinhaber: **SCHERING AKTIENGESELL-SCHAFT Berlin und Bergkamen**
**Müllerstrasse 170/178 Postfach 65 03 11**
**W-1000 Berlin 65(DE)**

(72) Erfinder: **Suhr, Harald, Prof. Dr. rer.nat.**
**Weissdornweg 2**
**W-7400 Tübingen(DE)**
Erfinder: **Oehr, Christian**
**Wintergasse 6**
**W-7403 Reusten(DE)**
Erfinder: **Feurer, Ernst**
**Ringstrasse 6**
**W-7400 Tübingen(DE)**

## Beschreibung

Die Erfindung befaßt sich mit der Aufgabe, elektrisch leitende Strukturen auf nichtleitenden Oberflächen herzustellen. Sie soll es insbesondere ermöglichen Glas, Kunststoffen und Leiterbahnen hoher Güte und Genauigkeit auf Keramik, Verbundmaterialien herzustellen, wie sie für zahlreiche Anwendungen in der Elektronik gefordert werden.

Die Herstellung solcher Leiterbahnen erfolgt normalerweise auf naßchemischem Wege, das heißt, die nichtleitende Oberfläche wird, nachdem sie mit einer Leiterbildmaske versehen wurde, in wäßrige Lösungen von Reinigungs- und Konditionierungsmitteln getaucht, danach in edelmetallhaltigen Lösungen (meist palladiumhaltige Lösungen) mit Edelmetall-Ionen "bekeimt". Diese Keime werden anschließend in Lösungen, die Reduktionsmittel enthalten, Metallatomen reduziert. Anschließend erfolgt die eigentliche Metallisierung in einem außenstromlos arbeitenden (chemisch-reduktiven) Kupfer- oder auch Nickelbad. Zwischen den Arbeitsgängen wird jeweils gründlich in reinem Wasser gespült.

Diese Arbeitsweise hat jedoch verschiedene Nachteile: Es sind zahlreiche Arbeits- und Spülvorgänge erforderlich.Dadurch ist die Gefahr groß, daß auch bei sorgfältiger Arbeitsweise Behandlungslösungen durch an den Substratoberflächen anhaftende Reste vorhergehender Lösungen verunreinigt werden und zu fehlerhaften Metallisierungen führen. Die Behandlungslösungen sind teilweise aggressiv und können zu Beschädigungen des Abdecklackes bzw. der Abdeckfolie führen; dadurch entstehen unsaubere Metallstrukturen, besonders bei feinen und feinsten ,Leiterbahnen , die zu teilweisem oder völligem Versagen der Leiterplatten beim späteren Gebrauch führen.

Die Aufgabe besteht deshalb darin, den gesamten naßchemischen Arbeitsablauf bis zur chemischen Verkupferug zu vermeiden. Dies wird durch das Verfahren gemäß Patentanspruch 1 erreicht. Man erhält dadurch Leiterzüge bis zu einer Dicke von etwa 2000 Å, die anschließend direkt - ohne weitere Vorbehandlung - in einem chemischen Kupfer- oder Nickelbad bis zur gewünschten Schichtdicke verstärkt werden können.

Plasmen (Glimmentladungen) werden in der Elektroindustrie bereits für verschiedene Zwecke eingesetzt. Bekannt ist zum Beispiel das Ätzen von Aluminiumoxidkeramiken im Plasma sowie das Ätzen von Silizium, Siliziumoxid und Siliziumnitrid.

Ein anderes Gebiet ist die Herstellung dünner Polymerschichten auf Festkörperoberflächen aus anorganischen Monomeren durch Glimmentladung.

So entstehen harte, widerstandsfähige Polymerfilme mit hohen Isolationswerten. zum Beispiel aus Acetylen, Styrol, Benzol Methan u.a. in Gegenwart von Trägergasen wie Helium und Argon. Befinden sich im Gasgemisch zusätzlic metallorganische Verbindungen wie zum Beispiel Tetramethylzinn - so erhält man polymere, organometallische Filme. Reine Metalloxidschichten die in der Sensorik und der Halbleiter-Elektronik eine große Rolle spielen, erhält man in gleicher Weise aus metallorganischen Verbindungen mit oder ohne Trägergase unter Einwirkung der Glimmentladung.

Auch die Zersetzung von Nickeltetracarbonyl zu metallischem Nickel und von Molybdänhexacarbonyl zu Molybdän-Kohlenstoff-Filmen wurde beschrieben, doch geben diese Techniken keinerlei Hinweise, bestimmte metallische Stukturen auf nichtleitenden Oberflächen zu erzeugen. Es muß außerdem berücksichtigt werden daß Metallcarbonyle hochgiftige - krebserzeugende Substanzen sind, die für einen technischen Einsatz nicht in Frage kommen.

Bekannt ist auch die thermische Zersetzung von metallorganischen Verbindungen im Vakuum, wobei auf dem Substrat metallische Schichten abgeschieden werden können. Hierbei muß aber das Substrat auf mindestens 200 ° C, in der Praxis auf 300-400 ° C, erhitzt werden.

Das erfindungsgemäße Verfahren, metallische Strukturen im Plasma zu erzeugen, hat demgegenüber den erheblichen Vorteil, daß die Temperatur des Substrates unter 100 ° C liegt, oft sogar nur zwischen Raumtemperatur und 80 ° C. Dadurch wird eine extrem schonende Behandlung des Werkstoffes erreicht, was insbesondere bei Kunststoffen von Wichtigkeit ist.

Desweiteren sind Zersetzungen von Wolframhexafluorid, Molybdänhexafluorid oder Wolframsilicid in einer Glimmentladungszone (Solid State Technology, Bd. 26, Nr. 3, März 1983, Seiten 125 - 128), sowie die Pyrolyse von Tetramethylzinn im Argon-Plasma (Thin Solid Films, Band 97, Nr. 1, November 1982, Seiten 17 - 29) und Verfahren zur Herstellung von Leiterbahnen auf Substrate (EP A 158 536) bekannt.

Zur Durchführung der Erfindung werden normale Plasmareaktoren benutzt, die hauptsächlich als Rohr- bzw. Tunnelreaktoren oder als Parallelplatten-Reaktoren bekannt sind. Für die Herstellung der metallischen Strukturen kann das Plasma sowohl mit Gleichstrom als auch mit Wechselstrom oder Hochfrequenz, im allgemeinen im Bereich zwischen 2 MHz und 50 MHz erzeugt werden. Der Druck in der Plasmakammer beträgt 0,1 - 2,0 hPa, es wird also - dies ist ein erheblicher Vorteil zum Beispiel gegenüber der Kathodenzerstäubung (sputtering) oder des Bedampfens - kein Hochvakuum mit Drücken von weniger als 3 Pa benötigt, die hohe Anforderungen an die Vakuumanlage stellen.

Als Substrate, auf denen die metallischen Strukturen erzeugt werden sollen, kommen alle üblichen anorganischen oder organischen Nichtleiter in Frage, insbesondere Aluminiumoxidkeramiken, Siliziumoxidkeramiken, Glas, Metalle mit Oxid- oder Nitridschichten oder Kunststoffe. Sie können als Festmaterialien oder als Folien vorliegen und einschichtig oder mehrschichtig sein.

Die Übertragung der Leiterbilder auf die Substrate erfolgt mit Hilfe von Siebdrucklacken, Fotolacken oder Fotoresistfilmen nach den bekannten Methoden der Additiv-, Semiadditiv- oder Subtraktivtechniken oder auch mit Hilfe von einfachen Masken.

Für die Bereitstellung von Metallatomen in der Glimmentladungszone zur Bildung von Metallschichten auf dem Substrat werden organische Metallverbindungen benutzt, die unter den angewandten Vakuumbedingungen flüchtig bzw. sublimierbar sind. Sie können für sich allein benutzt werden, im allgemeinen verdünnt man sie aber mit Trägergasen, um gleichmäßige, zusammenhängende und porenfreie Schichten zu erhalten. Als Trägergase sind inerte Gase wie Argon oder Helium oder reduzierende Gase wie Wasserstoff geeignet; auch Gemische davon können eingesetzt werden. Die Einspeisung der Organo-Metallverbindungen erfolgt nach Herstellen des Vakuums außerhalb der Glimmentladungszone in den Strom des Trägergases, so daß im eigentlichen Reaktionsbereich eine gleichmä-ßige Gasmischung vorliegt. Der Vorratsbehälter für die Metallverbindung wird zweckmäßigerweise mit einer Vorrichtung zum Heizen versehen, um schwerer sublimierbare Metallverbindungen in ausreichender Menge in den Gasstrom zu führen.

Die folgenden Beispiele erläutern die Erfindung:

BEISPIEL 1:    Abscheidung von Kupfer auf Keramik

| | |
|---|---|
| Substrat | – Aluminiumoxidkeramik |
| Metallorganische Verbindung | – Kupferhexafluoracetonylacetat |
| Heizung des Vorratsbehälters | – 60°C |
| Trägergas | – Argon |
| Reaktor | – Parallelplatten-Reaktor |
| Elektrodentemperatur | –. 40°C |
| Frequenz | – 13,56 MHz |
| Leistungsdichte | – 0,3 Watt/cm² |
| Druck im Reaktor | – 0,5 hPa |
| Einwirkungszeit im Plasma | – 90 Minuten. |

Keramikplättchen der Größe 50 x 50 x 1,5 mm werden auf die untere Elektrode des Reaktors gelegt. Der Reaktor wird auf den angegebenen Druck evakuiert und das Plasma gezündet. Die Kupferverbindung wird durch Erwärmen sublimiert und mit dem Trägergas in die Glimmentladungszone gebracht. Innerhalb von 90 min wird auf der Keramikoberfläche ein gleichmäßiger, porenfreier Kupferfilm von 600 - 800 Å Dicke abgeschieden.

Danach werden die Keramikplatten aus dem Reaktor entfernt und direkt - ohne weitere Vorbehandlung - mit einem Fotoresist beschichtet. Es erfolgt das Auflegen des Leiterbahnbildes, Belichten und Entwickeln nach den bekannten Methoden der Leiterplatten-Herstellung.

Nach dem Entwickeln werden die Leiterbahnen in einem chemischreduktiven Kupferbad auf die gewünschte Dicke verstärkt. Schließlich wird der ausgehärtete Resistfilm entfernt und der darunter befindliche 600 - 800 Å dicke Kupferfilm von der Plasmabeschichtung entfernt.

Man erhält ein Leiterbild mit feinsten Strukturen und nahezu senkrechten Leiterbahnflanken.

BEISPIEL 2: Abscheidung von Zinn auf Glas

| | |
|---|---|
| Substrat | – Silikatglas, mit einer Negativmaske der gewünschten Strukturen abgedeckt |
| Metallorganische Verbindung | – Tetramethylzinn |
| Trägergas | – Helium |
| Reaktor | – Parallelplatten-Reaktor |
| Elektrodentemperatur | – 100°C |
| Frequenz | – 27,12 MHz |
| Leistungsdichte | – 0,6 Watt/cm² |
| Druck im Reaktor | – 0,4 hPa |
| Einwirkungszeit im Plasma | – 60 Minuten |

Glasplatten der Größe 30 x 40 x 2 mm werden mechanisch mit einer Maske aus nichtrostendem Stahl oder aus Kunststoff-Folie in der Weise abgedeckt, daß die Bereiche der Glasoberfläche, die metallische Strukturen erhalten sollen, frei bleiben.

Die Platten werden auf die untere Elektrode des Reaktors gelegt, der Reaktor wird evakuiert und das Plasma gezündet. Tetramethylzinn wird mit dem Trägergas in die Glimmentladungszone gebracht. Innerhalb von 60 min. wird auf der Substratoberfläche ein gleichmäßiger, glänzender Zinnfilm, der Anteile an Kohlenstoff enthalten kann, in einer Dicke von 700 - 1000 Å abgeschieden.

Die Platten werden anschließend aus dem Reaktor herausgenommen, die Maske wird von der Oberfläche entfernt. Man erhält eine genaue Wiedergabe der Strukturen, die durch die Maske vorgegeben sind. Die Metallschicht kann in einem chemischreduktiven Bad verstärkt werden. Zu gleichen Ergebnissen gelangt man, wenn man keine mechanisch aufzulegenden Masken benutzt, sondern die Strukturen mit Hilfe von Siebdruck- oder Fotolacken erzeugt, bevor man die Behandlung im Plasma vornimmt.

BEISPIEL 3: Abscheidung von Palladium auf Polyimidfolien

| | |
|---|---|
| Substrat | – Polyimidfolie 40 x 65 x 0,1 mm |
| Metallorganische Verbindung | – $\pi$-Allyl-$\pi$-Cyclopentadienyl-Palladium (II) |
| Heizung des Vorratsbehälters | – nicht erforderlich |
| Trägergas | – Argon |
| Reaktor | – Parallelplatten-Reaktor |
| Elektrodentemperatur | – 30°C |
| Spannung | – Gleichspannung 300 V |
| Leistung | – 30 Watt |
| Leistungsdichte | – 0,1 Watt/cm² |
| Druck im Reaktor | – 0,15 hPa |
| Einwirkungszeit im Plasma | – 10 Minuten |

Die Herstellung der Strukturen aus Palladium kann entweder nach Beispiel 1 mit Hilfe von Fotoresisten oder nach Beispiel 2 durch Auflegen von Masken erfolgen. Man erhält in der angegebenen Zeit einen glänzenden Palladiumfilm von etwa 1000 Å Dicke.

**Patentansprüche**

1. Verfahren zum Herstellen von Leiterbahnen auf Nichtleitern, wobei die Abscheidung eines metallischen Films durch Zersetzung metallhaltiger Verbindungen in einer Glimmentladungszone erfolgt, dadurch gekennzeichnet, daß als metallhaltige Verbindungen metallorganische Verbindungen verwendet werden, worauf der in der Glimmentladungszone erhaltene Metallfilm in einem Bad zur chemisch-reduktiven Metallabscheidung verstärkt wird.

2. Verfahren nach Anspruch 1, dadurch gekennzeichnet, daß die daß die Strukturen durch Auflegen von Masken oder durch Auftragen von Siebdrucklacken oder Fotolacken vor der Plasmabehandlung vorgegeben werden.

3. Verfahren nach Anspruch 1, dadurch gekennzeichnet, daß die Strukturen nach der Plasmabehandlung mit Hilfe von Fotoresist, Fotolacken oder Siebdrucklacken erzeugt werden.

4. Verfahren nach Anspruch 1, dadurch gekennzeichnet, daß zur Abscheidung eines metallischen Films organische Kupferverbindungen benutzt werden.

5. Verfahren nach Anspruch 1, dadurch gekennzeichnet, daß zur Abscheidung eines metallischen Films organische Zinnverbindungen benutzt werden.

6. Verfahren nach Anspruch 1, dadurch gekennzeichnet, daß zur Abscheidung eines metallischen Films organische Palladiumverbindungen benutzt werden.

7. Verfahren nach Anspruch 1, dadurch gekennzeichnet, daß die Verstärkung des Metallfilms in einem chemisch-reduktiven Kupferbad vorgenommen wird.

8. Verfahren nach Anspruch 1, dadurch gekennzeichnet, daß die Verstärkung des Metallfilms in einem chemisch-reduktiven Nickelbad vorgenommen wird.

**Claims**

1. Method for the manufacture of conductor patterns on non-conducting materials, a metallic film being deposited by the decomposition of metal-containing compounds in a glow discharge zone, characterized in that organometallic compounds are used as the metal compounds, whereupon the metal film obtained in the glow discharge zone is reinforced in a bath for the chemical/reductive deposition of metal.

2. Method in accordance with Claim 1, characterized in that the patterns are predetermined by applying masks or screen printing resists or photosensitive resists prior to plasma treatment.

3. Method in accordance with Claim 1, characterized in that the patterns are produced after plasma treatment with the help of photo-resists, photosensitive resists or screen printing resists.

4. Method in accordance with Claim 1, characterized in that organic copper compounds are used to deposit a metallic film.

5. Method in accordance with Claim 1, characterized in that organic tin compounds are used to deposit a metallic film.

6. Method in accordance with Claim 1, characterized in that organic palladium compounds are used to deposit a metallic film.

7. Method in accordance with Claim 1, characterized in that the metal film is reinforced in a chemically reductive copper bath.

8. Method in accordance with Claim 1, characterized in that the metal film is reinforced in a chemically reductive nickel bath.

**Revendications**

1. Procédé de fabrication de câblage imprimé sur les non-conducteurs, avec dépôt d'un film métallique par décomposition de composés métallifères dans une zone de décharge d'effluves, caractérisé en ce que l'on utilise comme composés métalliques des composées organométalliques, après quoi le film métallique obtenu dans la zone de décharge d'effluves est renforcé dans un bain de dépôt métallique chimiquement réducteur.

2. Procédé suivant revendication 1, caractérisé en ce que les structures sont prédéfinies par l'application de caches ou de laque pour sérigraphie ou de laque photosensible avant le traitement au plasma.

3. Procédé suivant revendication 1, caractérisé en ce que les structures sont produites après le traitement au plasme à l'aide de produit photorésistant, de laque photosensible ou de laque pour sérigraphie.

4. Procédé suivant revendication 1, caractérisé en ce que des composés organiques à base de cuivre sont utilisés pour le dépôt d'un film métallique.

5. Procédé suivant revendication 1, caractérisé en ce que des composés organiques à base d'étain sont utilisés pour le dépôt d'un film métallique.

6. Procédé suivant revendication 1, caractérisé en ce que des composés organiques à base de palladium sont utilisés pour le dépôt d'un film métallique.

7. Procédé suivant revendication 1, caractérisé en ce que le renfort du film métallique est obtenu dans un bain de cuivre chimiquement réducteur.

8. Procédé suivant revendication 1, caractérisé en ce que le renfort du film métallique est obtenu dans un bain de nickel chimiquement réducteur.